# EUROPEAN PATENT SPECIFICATION

(11) **EP 3 367 642 B1**
(45) Date of publication and mention of the grant of the patent: **22.12.2021**
(21) Application number: 17765887.9
(22) Date of filing: 18.03.2017
(51) Int. Cl.: H04M 1/02, B23K 26/38, H01Q 1/24, B23K 26/60

(54) **METHOD FOR MACHINING CLEARANCE AREA OF HOUSING**
VERFAHREN ZUR BEARBEITUNG DES FREIRAUMS EINES GEHÄUSES
PROCÉDÉ D'USINAGE D'UNE ZONE DE DÉGAGEMENT D'UN BOÎTIER

(30) Priority: 18.03.2016 CN 201610157104
(43) Date of publication of application: 29.08.2018
(73) Proprietor: GUANGDONG OPPO MOBILE TELECOMMUNICATIONS CORP., LTD., Wusha, Chang'an Dongguan, Guangdong 523860 (CN)
(72) Inventor: LI, Jing, Dongguan Guangdong 523860 (CN); YANG, Guangming, Dongguan Guangdong 523860 (CN)
(74) Representative: Mewburn Ellis LLP
(86) International application number: PCT/CN2017/077165
(87) International publication number: WO 2017/157345

(56) References cited:
- EP-A2- 2 764 975
- CN-A- 103 022 638
- CN-A- 104 540 341
- CN-A- 104 580 585
- CN-A- 104 821 438
- CN-A- 105 657 101
- CN-U- 205 610 699
- US-A1- 2016 072 932

## Description

### TECHNICAL FIELD

This disclosure relates to a method for manufacturing a clearance area of a housing.

### BACKGROUND

With the improvement of science and technology, and the requirement of market, a demand for full metal mobile phones is more and more strong. The full metal mobile phones is beautiful, but, a full metal housing will block a radio-frequency signal of an antenna.

In related art, a certain clearance area is manufactured by a numerical control machine on back of the full metal mobile phones, to let the radio-frequency signal passing through. But the inventor finds that, when performing the above process, it is impossible to machine a clearance area with certain shape, or the clearance area is too large to preserve appearance integrity of the mobile phone, due to limitations of a numerical control machine tool or a control mode.

CN104 540 341 A , on which the preamble of claim is based, discloses a shell, which comprises a metal substrate and a non-conductor part, wherein the non-conductor part is combined to at least parts of area of the inner surface of the metal substrate; gaps are formed in parts of area of the metal substrate; and the non-conductor part forms the bottoms of the gaps.

EP 2 764 975 A2 discloses an electronic device including a plurality of electronic parts; one or more housing components forming a space for receiving the plurality of electronic parts; and a cover detachable from the one or more housing components, the cover including a first member having a plurality of metal elements suspended in a non-metal base and a second member coupled to the first member.

### SUMMARY

The disclosure provides a method for manufacturing a clearance area of a housing, which can machine a housing with a clearance area having certain shape, and can preserve the appearance integrity of the housing.

Embodiments of the present disclosure provide a method for manufacturing a clearance area of a housing. The method includes: providing a housing, the housing being made of signal shielding material and defining a predetermined area, and the housing in the predetermined area having a first surface and a second surface opposite to the first surface; forming at least one support structure on the first surface in the predetermined area, whereby the at least one support structure protrudes from the first surface; cutting out, on the second surface, a predetermined number of micro slits by using a laser cutter, the predetermined number of micro slits penetrating from the second surface to the first surface and being spaced with each other and arranged side-by-side, each of the at least one support structure stretching across the predetermined number of micro slits, to connect the housing into a whole; filling each of the predetermined number of micro slits with non-signal shielding material, to obtain a clearance area; and cutting off the at least one support structures; wherein a width of each of the predetermined number of micro slits (1) is in a range from 0.05 millimeters to 0.15 millimeters.

### BRIEF DESCRIPTION OF THE DRAWINGS

FIG. 1 is a flowchart illustrating a method for manufacturing a clearance area of a housing, according to one embodiment of the disclosure.
FIG. 2 is a flowchart illustrating another method for manufacturing a clearance area of a housing, according to one embodiment of the disclosure.
FIG. 3 is a schematic view of a housing, according to one embodiment of the disclosure.

### DETAILED DESCRIPTION OF ILLUSTRATED EMBODIMENTS

The present disclosure will now be described in detail and completely with reference to the accompanying drawings of the embodiments. It is to be understood that the specific embodiments described herein are merely illustrative but not all embodiments of the disclosure.

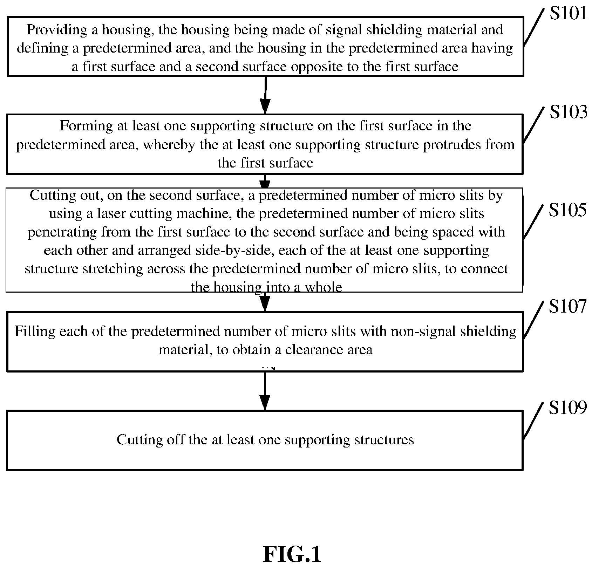

A method for manufacturing a clearance area of a housing is described in detail below with reference to FIG.1 to FIG.2.

Referring to FIG. 1, FIG. 1 is a flowchart illustrating the method for manufacturing the clearance area of the housing, according to one embodiment of the disclosure. As illustrated in FIG. 1, the method for manufacturing the clearance area of the housing in this exemplary embodiment can includes the following actions at block S101 to block S109.

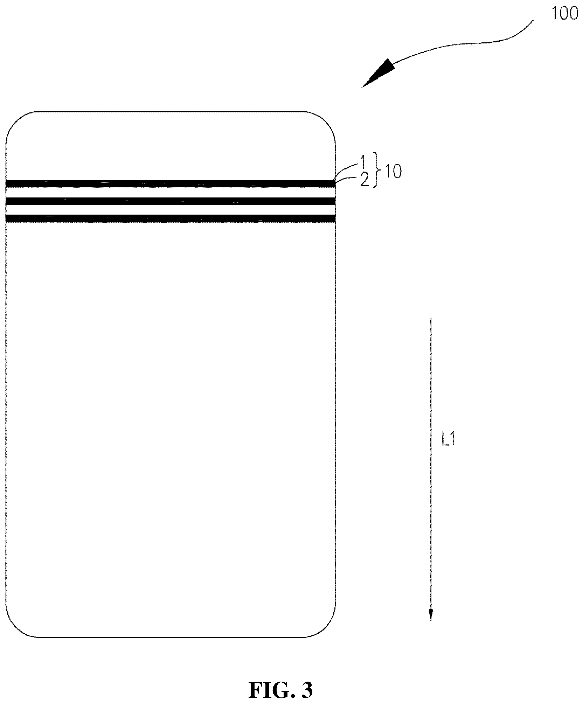

At block S101: further referring to FIG. 3, a housing is provided. The housing is made of a signal shielding material, and defines a predetermined area. The housing in the predetermined areahas a first surface and a second surface opposite to the first surface.

Specifically, the housing can be made according to actual needs. It will be apparent that, the housing can be a rear cover of a mobile terminal. The predetermined area is at a certain region of the housing according to actual needs. The predetermined area is a certain region of the housing needing to let the radio frequency signal passing through. The first surface can be an inner surface of the rear cover, and the second surface can be an outer surface of the rear cover. The outer surface is exposed to the air, that is, the outer surface is a surface can be directly contact by user. In other exemplary embodiments, the housing can be a rear housing or a back cover with a border.

In one exemplary embodiment, the housing can be manufactured by the following method: a metal plate is received in a mold and is stamped into a metal board having a predetermined shape; an inner structure and an outer shape of the metal board having the predetermined shape are processed by a numerical control machine, to obtain the housing. The metal plate is an aluminum plate. A large aluminum plate panel is cut into a plurality of small aluminum plates. The cut aluminum plates are received in a mold for pressing to form metal boards with the predetermined shape. It will be apparent that, the aluminum plate can be pressed once or can be continuously pressed for multiple times. The metal board is processed by a numerical control machine to obtain a demand housing.

At block S103: at least one support structure is manufactured on the first surface in the predetermined area, whereby the at least one support structure protrudes from the first surface.

Specifically, a extending direction of the at least one support structure is a longitudinal direction of the housing. The at least one support structure is defined to be three support structures. The three support structures are spaced with each other and are sequentially arranged on the first surface in the predetermined area along a transverse direction of the housing. The first surface is the inner surface. The transverse direction is a width direction. Thus, when cutting off the three support structures later, a cutting mark left on the first surface will be located inside the mobile terminal. The cutting mark can only be observed when disassembled the mobile terminal, therefore, the cutting mark will not undermine the appearance integrity of the mobile terminal. It will be apparent that, each of the at least one support structure is shaped as a bridge pier, to avoid a deformation on the housing in a laser cutting process. In other embodiments, the at least one support structure can be other structures, as long as the at least one support structure can provide a supporting, for example, the at least one support structure is at least a stiffener or at least a rib. In other embodiments, other numbers of the at least one support structures can be provided.

At block S105: a laser cutter aims on and cuts the second surface of the predetermined area, to form a predetermined number of micro slits. The predetermined number of micro slits are spaced with each other and are arranged side-by-side. Each of the at least one support structure stretches across the predetermined number of micro slits, to connect the housing into a whole.

Specifically, lasers of an optical fiber laser cutter of large power is used to cut the housing from the first surface to penetrate the second surface, to form the predetermined number of micro slits 1. The predetermined number of micro slits 1 is defined to be three micro slits 1. The three micro slits 1 are spaced with each other and are sequentially arranged along a longitudinal direction of the housing, which is also a length direction. Wherein, through a lot of experiments, the inventor develops that, through the method of embodiments of the disclosure, a width of each of the predetermined number of micro slits 1 is in a range from 0.05 millimeters to 0.15 millimeters, that is, the predetermined number of micro slits 1 is barely visible to the naked eye, which can ensure the radio frequency signal of the antenna of the mobile terminal to pass through and can improve an integrity of outer structure of the housing. In this exemplary embodiment, the width of each of the predetermined number of micro slits 1 is 0.06 millimeters. Each of the at least one support structures stretches across the three micro slits 1, that is each of the at least one support structure covers the three micro slits 1, to form a good support structure. In other embodiments, other numbers of the predetermined number of micro slits 1 can be provided.

In one exemplary embodiment, an auxiliary cooling processing is performed during a laser cutting processing, to lower the temperature in the laser cutting processing, to form the remand micro slits 1. It will be apparent that, the auxiliary cooling processing can be a high-pressure nitrogen-assisted cooling processing..

At block S107: a non-signal shielding material 2 is filled in each of the predetermined number of micro slits 1, to obtain a clearance area 10.

Specifically, the housing having the clearance area 10 is etched. Wherein, the non-signal shielding material 2 is a material which can let the radio frequency signal passing through. It will be apparent that, the non-signal shielding material 2 can be plastic. Wherein, nano-injection filling is performed on each of the predetermined number of micro slits 1, to obtain the clearance area 10. The radio frequency signal can pass through each of the predetermined number of micro slits 1 filled with the non-signal shielding material 2, that is, the predetermined number of micro slits 1 forms to be the clearance area 10 of the antenna.

At block S109: the at least one support structures is cut off.

Specifically, the at least one support structures is cut off by a numerical control machine, and structures on other portions of the housing are simultaneously finished.

The method for manufacturing the clearance area of the housing provided by embodiments of the disclosure, includes cutting the housing to obtain a predetermined number of micro slits by laser, and filling a non-signal shielding material in each of the predetermined number of micro slits to form the clearance area, which can obtain the clearance area with a certain shape; and for the width of the predetermined number of micro slits is small, a usage of the non-signal shielding material is reduced, and that can preserve the appearance integrity of the housing.

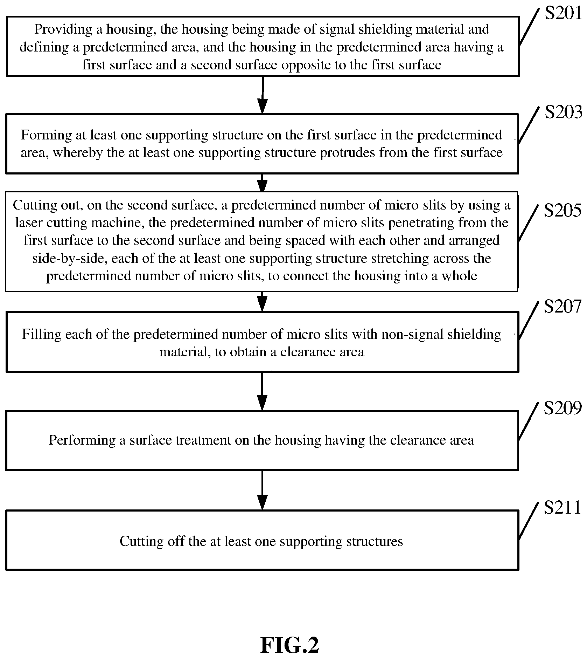

Referring to FIG. 2, FIG. 2 is a flowchart illustrating another method for manufacturing a clearance area of a housing, according to one embodiment of the disclosure. As illustrated in FIG. 2, the method for manufacturing the clearance area of the housing in this embodiment can includes the following actions at block S201 to block S211.

At block S201: further referring to FIG. 3, a housing is provided. The housing is made of a signal shielding material, and defines a predetermined area. The housing on the predetermined area has a first surface and a second surface opposite to the first surface.

Specifically, the housing can be made according to actual needs. It will be apparent that, the housing can be a rear cover of a mobile terminal. The predetermined area is at a certain region of the housing according to actual needs. The predetermined area is a certain region of the housing needing to let the radio frequency signal passing through. The first surface can be an inner surface of the rear cover, and the second surface can be an outer surface of the rear cover. The outer surface is exposed to air, that is the outer surface is a surface can be directly contact by user. In other exemplary embodiments, the housing can be a rear housing or a back cover with a border.

In one exemplary embodiment, the housing can be manufactured by the following method: a metal plate is received in a mold and is stamped into a metal board having a predetermined shape; an inner structure and an outer shape of the metal board having the predetermined shape are processed by a numerical control machine, to obtain the housing. The metal plate is an aluminum plate. A large aluminum plate panel is cut into a plurality of small aluminum plates. The cut aluminum plates are received in a mold for pressing to form metal boards with the predetermined shape. It will be apparent that, the aluminum plate can be pressed once or can be continuously pressed for multiple times. The metal board is processed by a numerical control machine to obtain a demand housing.

At block S203: at least one support structure is manufactured on the first surface in the predetermined area, whereby the at least one support structure protrudes from the first surface.

Specifically, the at least one support structure is defined to be three support structures. The three support structures are spaced with each other and are sequentially arranged on the first surface in the predetermined area along a transverse direction of the housing. The first surface is the inner surface, and the transverse direction is a width direction. Thus, when cutting off the three support structures later, a cutting mark left on the first surface will be located inside the mobile terminal. The cutting mark can only be observed when disassembled the mobile terminal, therefore, the cutting mark will not undermine the appearance integrity of the mobile terminal. It will be apparent that, each of the at least one support structure is shaped as a bridge pier, to avoid a deformation on the housing in a laser cutting process. In other embodiments, the at least one support structure can be other structures, as long as the at least one support structure can provide a supporting, for example, the at least one support structure is at least a stiffener or at least a rib. In other embodiments, other numbers of the at least one support structures can be provided.

At block S205: a laser cutter aims on and cuts the second surface in the predetermined area, to form a predetermined number of micro slits 1. The predetermined number of micro slits 1 are spaced with each other and are arranged side-by-side. Each of the at least one support structure stretches across the predetermined number of micro slits 1, to connect the housing into a whole.

Specifically, a extending direction of the predetermined number of micro slits 1 is a transverse direction of the housing. Laserslasers of an optical fiber laser cutter with large power is used to cut the housing from the first surface to penetrate the second surface, to form the predetermined number of micro slits 1. The predetermined number of micro slits 1 is defined to be three micro slits 1. The three micro slits 1 are spaced with each other and are sequentially arranged along a longitudinal direction of the housing, which is also a length direction. Wherein, through a lot of experiments, the inventor develops that, through the method of embodiments of the disclosure, a width of each of the predetermined number of micro slits 1 is in a range from 0.05 millimeters to 0.15 millimeters, that is, the predetermined number of micro slits 1 is barely visible to the naked eye, which can ensure the radio frequency signal of the antenna of the mobile terminal to pass through and can improve an integrity of outer structure of the housing. In this exemplary embodiment, the width of each of the predetermined number of micro slits 1 is 0.06 millimeters. Each of the at least one support structures stretches across the three micro slits 1, that is each of the at least one support structure covers the three micro slits 1, to form a good support structure. In other embodiments, other numbers of the predetermined number of micro slits 1 can be provided.

In one exemplary embodiment, an auxiliary cooling processing is performed during a laser cutting processing, to lower the temperature in the laser cutting processing, to form the remand micro slits 1. It will be apparent that, the auxiliary cooling processing can be a high-pressure nitrogen-assisted cooling processing.

At block S207: a non-signal shielding material 2 is filled in each of the predetermined number of micro slits 1, to obtain a clearance area 10.

Specifically, the housing having the clearance area 10 is etched. Wherein, the non-signal shielding material 2 is a material which can let the radio frequency signal passing through. It will be apparent that, the non-signal shielding material 2 can be plastic. Wherein, nano-injection filling is performed on each of the predetermined number of micro slits 1, to obtain the clearance area 10. The radio frequency signal can pass through each of the predetermined number of micro slits 1 filled with the non-signal shielding material 2, that is, the predetermined number of micro slits 1 forms to be the clearance area 10 of the antenna.

At block S209, the housing having the clearance area 10 is performed by a surface treatment process.

Specifically, the housing having the clearance area 10 is processed by a surface polishing process, a sandblasting process, and an anodizing processes, to form an outer surface with multiple colors, to improve properties of the housing.

At block S211: the at least one support structures is cut off.

Specifically, the at least one support structures is cut off by a numerical control machine, and structures on other portions of the housing are simultaneously finished.

The method for manufacturing the clearance area of the housing provided by embodiments of the disclosure, includes cutting the housing to obtain a predetermined number of micro slits by laser, and filling a non-signal shielding material in each of the predetermined number of micro slits to form the clearance area, which can obtain the clearance area with a certain shape; and for the width of the predetermined number of micro slits is small, a ratio of the non-signal shielding material is lessening, and that can preserve the appearance integrity of the housing.

The predetermined number of micro slits 1 is defined to be three micro slits. The three micro slits 1 are spaced with each other and are sequentially arranged on the housing, along a longitudinal direction L1 of the housing, which is a length direction.

It will be apparent that, for preserve the integrity of outer structure of the housing 100, a width of each of the predetermined number of micro slits 1 is in a range from 0.05 millimeters to 0.15 millimeters. In this exemplary embodiment, the width of each of the predetermined number of micro slits 1 is 0.06 millimeters. A distance between each two adjacent micro slits 1 is larger than the width of each of the predetermined number of micro slits 1, to further improve the integrity of outer structure of the housing 100. The housing 100 and the mobile terminal 200 provided by embodiments of the disclosure have the clearance area with a certain shape and a small area, which can preserve the integrity of outer structure of the housing.

## Claims

1. A method for manufacturing a clearance area (10) of a housing (100), comprising:
providing a housing (101), the housing (101) being made of signal shielding material and defining a predetermined area (102), and the housing (101) in the predetermined area (102) having a first surface (103) and a second surface opposite to the first surface (103) (S101, S201); and **characterized by**:
forming at least one support structure (104) on the first surface (103) in the predetermined area (102), whereby the at least one support structure (104) protrudes from the first surface (103) (S103, S203);
cutting out, on the second surface, a predetermined number of micro slits (1) by using a laser cutter, the predetermined number of micro slits (1) penetrating from the second surface to the first surface (103) and being spaced with each other and arranged side-by-side, each of the at least one support structure (104) stretching across the predetermined number of micro slits (1), to connect the housing (101) into a whole (S105, S205);
filling each of the predetermined number of micro slits (1) with non-signal shielding material (2), to obtain a clearance area (10) (S107); and
cutting off the at least one support structures (104) (S109, S211), wherein a width of each of the predetermined number of micro slits (1) is in a range from 0.05 millimeters to 0.15 millimeters.

2. The method according to claim 1, wherein the housing (100) is a rear cover of a mobile terminal (200).

3. The method according to claim 2, wherein the first surface (103) is an inner surface of the rear cover, and the second surface is an outer surface of the rear cover.

4. The method according to claim 3, further comprising manufacturing the housing (101), wherein the manufacturing of the housing (101) comprises:
receiving in a mold a metal plate and pressing the metal plate to form a metal board having a predetermined shape; and
processing an inner structure and an outer shape of the metal board having the predetermined shape by a numerical control machine, to obtain the housing (101).

5. The method according to claim 4, the receiving a metal plate in a mold and pressing the metal plate to form a metal board having a predetermined shape, comprising:
cutting the metal plate a plurality of times, receiving in the mold the metal plate subjected to cutting, and pressing the metal plate to form the metal board having the predetermined shape.

6. The method according to claim 1, wherein the at least one support structure (104) is spaced with each other and is sequentially arranged on the first surface (103) in the predetermined area (102) along a transverse direction of the housing (101).

7. The method according to claim 6, wherein the at least one support structure (104) is at least a stiffener or at least a rib.

8. The method according to claim 1, cutting out, on the first surface (103), a predetermined number of micro slits (1) by using a laser cutter, comprising:
performing an auxiliary cooling processing during a laser cutting processing, wherein the auxiliary cooling processing is a high-pressure nitrogen-assisted cooling processing.

9. The method according to claim 1, the filling a non-signal shielding material (2) in each of the plurality of micro slits (1), comprising:
performing nano-injection filling on each of the plurality of micro slits (1), to obtain the clearance area (10).

10. The method according to claim 1, further comprising the follows after filling each of the predetermined number of micro slits (1) with non-signal shielding material (2):
performing a surface treatment on the housing (101) having the clearance area (10) (S209), wherein the surface treatment comprises one or more selected from a group consisting of a surface polishing process, a sandblasting process, and an anodizing processes.

11. The method according to claim 1, the cutting off the at least one support structures (104) (S109, S211) comprising:
cutting off the at least one support structures (104) by a numerical control machine.

## Patentansprüche

1. Verfahren zum Herstellen eines Freibereichs (10) eines Gehäuses (100), das Folgendes umfasst:
Bereitstellen eines Gehäuses (101), wobei das Gehäuse (101) aus einem Signalabschirmungsmaterial besteht und einen vorbestimmten Bereich (102) definiert und wobei das Gehäuse (101) im vorbestimmten Bereich (102) eine erste Fläche (103) und eine zweite Fläche gegenüber der ersten Fläche (103) (S101, S201) aufweist und **gekennzeichnet durch**:
Bilden von mindestens einer Stützstruktur (104) auf der ersten Fläche (103) im vorbestimmten Bereich (102),
wodurch die mindestens eine Stützstruktur (104) von der ersten Fläche (103) vorsteht (S103, S203);
Ausschneiden einer vorbestimmten Anzahl von Mikroschlitzen (1) auf der zweiten Fläche unter Verwendung eines Laserschneiders, wobei die vorbestimmte Anzahl von Mikroschlitzen (1) die zweite Fläche zur ersten Fläche (103) durchdringen und voneinander beabstandet sowie Seite an Seite angeordnet sind, wobei sich jede der mindestens einen Stützstruktur (104) über die vorbestimmte Anzahl von Mikroschlitzen (1) erstreckt,
um das Gehäuse (101) zu einem Ganzen zu verbinden (S105, S205);
Füllen von jedem der vorbestimmten Anzahl von Mikroschlitzen (1) mit Nichtsignalabschirmungsmaterial (2), um einen Freibereich (10) zu erhalten (S107); und Abschneiden der mindestens einen Stützstruktur (104) (S109, S211), wobei eine Breite von jedem der vorbestimmten Anzahl von Mikroschlitzen (1) in einer Spanne von 0,05 Millimeter bis 0,15 Millimeter liegt.

2. Verfahren nach Anspruch 1, wobei das Gehäuse (100) eine hintere Abdeckung eines mobilen Endgeräts (200) ist.

3. Verfahren nach Anspruch 2, wobei die erste Fläche (103) eine Innenfläche der hinteren Abdeckung ist und die zweite Fläche eine Außenfläche der hinteren Abdeckung ist.

4. Verfahren nach Anspruch 3, das ferner das Herstellen des Gehäuses (101) umfasst, wobei das Herstellen des Gehäuses (101) Folgendes umfasst:
Aufnehmen einer Metallplatte in eine Gussform und Pressen der Metallplatte, um eine Metalltafel mit einer vorbestimmten Form zu bilden; und
Verarbeiten einer inneren Struktur und einer äußeren Form der Metalltafel, die die vorbestimmte Form aufweist, mit einer numerischen Steuermaschine, um das Gehäuse (101) zu erhalten.

5. Verfahren nach Anspruch 4, wobei das Aufnehmen einer Metallplatte in eine Gussform und Pressen der Metallplatte, um eine Metalltafel mit einer vorbestimmten Form zu bilden, Folgendes umfasst:
mehrfaches Schneiden der Metallplatte, Aufnehmen der dem Schneiden unterzogenen Metallplatte in die Gussform und
Pressen der Metallplatte, um die Metalltafel mit der vorbestimmten Form zu bilden.

6. Verfahren nach Anspruch 1, wobei die mindestens eine Stützstruktur (104) voneinander beabstandet und sequenziell auf der ersten Fläche (103) im vorbestimmten Bereich (102) entlang einer Querrichtung des Gehäuses (101) angeordnet ist.

7. Verfahren nach Anspruch 6, wobei die mindestens eine Stützstruktur (104) mindestens eine Versteifung oder mindestens eine Rippe ist.

8. Verfahren nach Anspruch 1, wobei das Ausschneiden einer vorbestimmten Anzahl von Mikroschlitzen (1) unter Verwendung eines Laserschneiders auf der ersten Fläche (103) Folgendes umfasst:
Durchführen einer Hilfskühlungsverarbeitung während einer Laserschneideverarbeitung, wobei die Hilfskühlungsverarbeitung eine hochdruckstickstoffgestützte Kühlungsverarbeitung ist.

9. Verfahren nach Anspruch 1, wobei das Füllen eines Nichtsignalabschirmungsmaterials (2) in jeden der Vielzahl von Mikroschlitzen (1) Folgendes umfasst:
Durchführen einer Nanoinjektionsfüllung an jedem der Vielzahl von Mikroschlitzen (1), um den Freibereich (10) zu erhalten.

10. Verfahren nach Anspruch 1, das nach dem Füllen von jedem der vorbestimmten Anzahl von Mikroschlitzen (1) mit Nichtsignalabschirmungsmaterial (2) Folgendes umfasst:
Durchführen einer Flächenbehandlung am Gehäuse (101), das den Freibereich (10) (S209) aufweist, wobei die Flächenbehandlung eines oder mehreres umfasst, das aus einer Gruppe ausgewählt ist, die aus einem Flächenpolierprozess, einem Sandstrahlprozess und einem Anodisierprozess besteht.

11. Verfahren nach Anspruch 1, wobei das Abschneiden der mindestens einen Stützstruktur (104) (S109, S211) Folgendes umfasst:
Abschneiden der mindestens einen Stützstruktur (104) mit einer numerischen Steuermaschine.

## Revendications

1. Procédé de fabrication d'une zone de dégagement (10) d'un boîtier (100), comprenant :
la mise à disposition d'un boîtier (101), le boîtier (101) étant fait d'un matériau de blindage contre les signaux et définissant une zone prédéterminée (102), et le boîtier (101) dans la zone prédéterminée (102) ayant une première surface (103) et une seconde surface opposée à la première surface (103) (S101, S201) ; et **caractérisé par** :
la formation d'au moins une structure de support (104) sur la première surface (103) dans la zone prédéterminée (102), dans lequel l'au moins une structure de support (104) fait saillie depuis la première surface (103) (S103, S203) ;
la découpe, sur la seconde surface, d'un nombre prédéterminé de micro-fentes (1) au moyen d'un dispositif de découpe au laser, les micro-fentes du nombre prédéterminé de micro-fentes (1) pénétrant depuis la seconde surface jusqu'à la première surface (103) et étant espacées les unes des autres et disposées côte à côte, chaque structure de l'au moins une structure de support (104) s'étirant à travers le nombre prédéterminé de micro-fentes (1), pour relier le boîtier (101) dans un ensemble (S105, S205) ;
le remplissage de chaque fente du nombre prédéterminé de micro-fentes (1) avec un matériau de non-blindage contre les signaux (2) pour obtenir une zone de dégagement (10) (S107) ; et
la découpe de l'au moins une structure de support (104) (S109, S211), dans lequel une largeur de chaque micro-fente du nombre prédéterminé de micro-fentes (1) se trouve dans une plage comprise entre 0,05 millimètres et 0,15 millimètres.

2. Procédé selon la revendication 1, dans lequel le boîtier (100) est un couvercle arrière d'un terminal mobile (200).

3. Procédé selon la revendication 2, dans lequel la première surface (103) est une surface intérieure du couvercle arrière et la seconde surface est une surface extérieure du couvercle arrière.

4. Procédé selon la revendication 3, comprenant en outre la fabrication du boîtier (101), dans lequel la fabrication du boîtier (101) comprend :
la réception dans un moule d'une plaque métallique et la pression de la plaque métallique pour former un panneau métallique présentant une forme prédéterminée ; et
le traitement d'une structure intérieure et d'une forme extérieure du panneau métallique présentant la forme prédéterminée au moyen d'une machine à commande numérique, pour obtenir le boîtier (101).

5. Procédé selon la revendication 4, dans lequel la réception dans un moule d'une plaque métallique et la pression de la plaque métallique pour former un panneau métallique présentant une forme prédéterminée comprend :
la découpe de la plaque métallique une pluralité de fois, la réception dans le moule de la plaque métallique soumise à la découpe et la pression de la plaque métallique pour former le panneau métallique présentant la forme prédéterminée.

6. Procédé selon la revendication 1, dans lequel les structures de l'au moins une structure de support (104) sont espacées les unes des autres et sont séquentiellement disposées sur la première surface (103) dans la zone prédéterminée (102) le long d'une direction transversale du boîtier (101).

7. Procédé selon la revendication 6, dans lequel l'au moins une structure de support (104) est un raidisseur ou au moins une nervure.

8. Procédé selon la revendication 1, dans lequel la découpe, sur la première surface (103), d'un nombre prédéterminé de micro-fentes (1) au moyen d'un dispositif de découpe au laser comprend :
l'exécution d'un traitement de refroidissement auxiliaire pendant un traitement de découpe au laser, dans lequel le traitement de refroidissement auxiliaire est un traitement de refroidissement à base d'azote sous haute pression.

9. Procédé selon la revendication 1, dans lequel le remplissage d'un matériau de non-blindage contre les signaux (2) dans chaque micro-fente de la pluralité de micro-fentes (1) comprend :
l'exécution d'un remplissage par nano-injection de chaque micro-fente de la pluralité de micro-fentes (1) pour obtenir la zone de dégagement (10).

10. Procédé selon la revendication 1, comprenant en outre l'étape suivante après le remplissage de chaque micro-fente de la pluralité de micro-fentes (1) par un matériau de non-blindage contre les signaux (2) :
l'exécution d'un traitement de surface sur le boîtier (101) présentant la zone de dégagement (10) (S209), dans lequel le traitement de surface comprend un ou plusieurs processus choisis parmi un processus de polissage de surface, un processus de sablage et un processus d'anodisation.

11. Procédé selon la revendication 1, dans lequel la découpe de l'au moins une structure de support (104) (S109, S211) comprend :
la découpe de l'au moins une structure de support (104) au moyen d'une machine à commande numérique.
